Europäisches Patentamt

European Patent Office

Office européen des brevets

(19)

(11) Numéro de publication : **0 130 865**
**B1**

(12) **FASCICULE DE BREVET EUROPÉEN**

(45) Date de publication du fascicule du brevet :
**15.03.89**

(21) Numéro de dépôt : **84401103.1**

(22) Date de dépôt : **29.05.84**

(51) Int. Cl.⁴ : **C 30 B 11/00**, C 30 B 29/12,
C 30 B 35/00

(54) Dispositif d'élaboration d'un monocristal.

(30) Priorité : **06.06.83 FR 8309338**

(43) Date de publication de la demande :
**09.01.85 Bulletin 85/02**

(45) Mention de la délivrance du brevet :
**15.03.89 Bulletin 89/11**

(84) Etats contractants désignés :
**DE GB NL**

(56) Documents cités :
**FR-A- 2 086 418**
**GB-A- 923 241**
**US-A- 2 214 976**
**US-A- 3 796 552**

(73) Titulaire : **COMMISSARIAT A L'ENERGIE ATOMIQUE**
**31/33, rue de la Fédération**
**F-75015 Paris (FR)**

(72) Inventeur : **Ferrand, Bernard**
**115, rue du Pianarot**
**F-38340 Voreppe (FR)**
Inventeur : **Grange, Yves**
**4, Cité Jean Macé**
**F-38000 Grenoble (FR)**

(74) Mandataire : **Mongrédien, André et al**
**c/o BREVATOME 25, rue de Ponthieu**
**F-75008 Paris (FR)**

Jouve, 18, rue St-Denis, 75001 Paris, France

## Description

La présente invention concerne un dispositif d'élaboration d'un monocristal. Elle s'applique notamment à l'élaboration de monocristaux utilisables comme scintillateurs et en particulier à l'élaboration de monocristaux de fluorure de baryum BaF$_2$.

On connaît des techniques d'élaboration de monocristaux, la plus utilisée étant la méthode de BRIDGMAN. Selon cette méthode, le matériau à cristalliser est disposé dans un creuset que l'on déplace dans un faible gradient de température, d'une zone de haute température vers une zone de basse température. La faiblesse du gradient de température rend indispensable la purification préalable du matériau, ce qui est généralement réalisé a l'aide de la méthode connue sous le nom de « fusion de zone ». Selon cette méthode, on chauffe une partie seulement d'un lingot du matériau à purifier, formant ainsi une mince couche en fusion et l'on fait ensuite se déplacer cette couche d'une extrémité du lingot à l'autre, les impuretés contenues dans ce lingot étant alors entraînées vers une extrémité de celui-ci. Il faut recommencer plusieurs fois cette opération pour obtenir un matériau très pur. En outre, l'utilisation d'un gradient thermique très abrupt provoque la cassure du lingot en plusieurs morceaux qui sont inutilisables en pratique étant donné leurs petites dimensions et auxquels on applique ensuite la méthode de BRIDGMAN pour obtenir un monocristal de taille convenable.

La technique associant la méthode de fusion de zone a la méthode de BRIDGMAN présente des inconvénients : c'est une technique longue et complexe qui nécessite beaucoup de manipulations du matériau à cristalliser, ce qui augmente les risques de pollution de celui-ci, pollution qui est bien entendu à éviter, surtout dans le cas des cristaux destinés à la réalisation de scintillateurs.

La présente invention a justement pour objet un dispositif d'élaboration d'un monocristal, qui ne présente pas les inconvénients de la technique précédemment rappelée, notamment en ce qu'il est plus simple, permet d'obtenir des vitesses de croissance de monocristaux assez élevées, de l'ordre de 2 à 10 mm/heure par exemple, ne nécessite que très peu de manipulation du matériau à cristalliser et évite donc toute pollution de celui-ci. En outre, il est complètement automatisable et permet d'obtenir des cristaux sur mesure, à l'unité ou en plusieurs exemplaires à la fois, ces cristaux pouvant de plus présenter toutes les formes souhaitées (cylindrique, parallélépipédique, ...).

On connaît déjà, par le document GB-A-923241, une technique de fabrication de monocristaux, selon laquelle on introduit les composants des monocristaux désirés dans un creuset présentant une fusion pâteuse. Le creuset est placé à son tour dans une enveloppe en graphite. On porte rapidement l'ensemble à une température de fusion des composants afin de ne produire qu'un minimum de décomposition de ces derniers. Le creuset se plaque contre l'enveloppe en graphite et les monocristaux sont obtenus par refroidissement sous gradient de température faible.

De façon précise, la présente invention a pour objet un dispositif d'élaboration d'un monocristal à partir d'un matériau apte à cristalliser, ce dispositif comprenant :

- au moins un creuset thermiquement conducteur, prévu pour recevoir le matériau,
- un moyen thermiquement conducteur apte à recevoir chaque creuset,
- des moyens de chauffage dudit moyen thermiquement conducteur et de chaque creuset contenant ledit matériau, ces moyens de chauffage ayant une longueur au moins égale à celle de chaque creuset, et
- des moyens de déplacement relatif dudit moyen thermiquement conducteur et de chaque creuset contenant ledit matériau par rapport auxdits moyens de chauffage ;

le moyen thermiquement conducteur comporte une partie supérieure, apte à recevoir chaque creuset, et une partie inférieure prolongeant inférieurement la partie supérieure et formant un appendice de cette partie supérieure, le fond de chaque creuset est de forme effilée, de façon à constituer des moyens de cristallisation aptes à provoquer la cristallisation d'une extrémité dudit matériau fondu dans les moyens de chauffage, ces moyens de chauffage permettant la sortie du moyen thermiquement conducteur par le bas desdits moyens de chauffage, et l'appendice est disposé de façon à modifier le gradient thermique subi par le matériau lors du déplacement relatif.

Les moyens de chauffage sont conçus pour provoquer une diminution abrupte de température du matériau chauffé par eux lorsqu'il en est extrait grâce auxdits moyens de déplacement, le moyen thermiquement conducteur est prévu pour contrôler cette diminution de température du matériau fondu par les moyens de chauffage, les moyens de déplacement relatif sont prévus pour soumettre le matériau à un gradient de température contrôlé et pour obtenir une cristallisation du matériau, celui-ci étant ensuite lentement refroidi jusqu'à la température ambiante.

Par « refroidissement lent », on entend un refroidissement ne dépassant pas quelques centaines de degrés Celsius par heure, par exemple un refroidissement de l'ordre de 50 à 100 °C/h.

Par « diminution abrupte de température », on entend une diminution du genre de celle que l'on réalise dans la méthode de fusion de zone, connue dans l'état de la technique.

Bien entendu, le moyen thermiquement conducteur peut être déplacé par rapport aux moyens de chauffage ou, au contraire, ces derniers peuvent être déplacés par rapport au moyen thermiquement conducteur.

Dans la présente invention, le moyen thermiquement conducteur est fondamental : il permet par conduction thermique, d'homogénéiser la température du matériau et d'atténuer la diminution abrupte de température que l'on peut également appeler « gradient thermique abrupt ». Le gradient thermique éprouvé par le matériau peut être modifié à volonté en modifiant la forme et/ou la nature du moyen thermiquement conducteur.

Selon la présente invention, le matériau est donc fondu dans les moyens de chauffage puis, par déplacement, émerge à une extrémité de ceux-ci. En cette extrémité, le matériau subit une diminution de température et il apparaît une interface liquide-solide dans le matériau. La diminution de température est suffisamment forte pour entraîner un rejet de toutes les impuretés du matériau dans sa partie liquide et donc pour purifier celui-ci, et suffisamment atténuée par le moyen thermiquement conducteur pour permettre une croissance monocristalline continue du matériau, au fur et à mesure qu'il émerge des moyens de chauffage, cette croissance monocristalline étant initiée par l'extrémité du matériau, sortie la première des moyens de chauffage.

La présente invention correspond donc à une technique intermédiaire entre la méthode de BRIDGMAN et la méthode de fusion de zone, tout en donnant à la fois les résultats que procurent ces deux méthodes, à savoir la purification du matériau et l'obtention d'un monocristal de taille convenable de ce matériau.

Selon une caractéristique particulière du dispositif objet de l'invention, celui-ci comporte plusieurs creusets, le moyen thermiquement conducteur comporte un évidement et les creusets sont disposés symétriquement autour de cet évidement. On évite ainsi une surchauffe locale du moyen thermiquement conducteur.

Selon une autre caractéristique préférée du dispositif objet de l'invention, le moyen thermiquement conducteur et chaque creuset sont en graphite purifié.

Selon une autre caractéristique préférée, les moyens de chauffage comportent des enroulements inducteurs à haute fréquence. Au lieu de cela, ils pourraient comporter des enroulements résistifs chauffant par effet Joule, mais le chauffage résultant serait alors moins homogène par suite d'un gradient radial plus important.

Selon une autre caractéristique particulière, l'ensemble constitué par le moyen thermiquement conducteur, chaque creuset et le matériau, est placé dans une enceinte l'isolant de l'atmosphère extérieure.

Enfin, de préférence, le dispositif objet de l'invention comporte en outre des moyens de circulation d'un gaz chimiquement inerte, de manière à élaborer le monocristal en atmosphère chimiquement inerte.

L'invention sera mieux comprise à la lecture de la description qui suit, d'exemples de réalisation donnés à titre indicatif et nullement limitatif, en référence aux dessins annexés sur lesquels :

- la figure 1 est une vue schématique d'un mode de réalisation particulier du dispositif objet de l'invention,

- les figures 2a à 2d sont des coupes transversales schématiques de modes de réalisation particuliers du moyen thermiquement conducteur et des creusets utilisés dans l'invention, et

- les figures 3a à 3c sont des graphiques montrant les différences entre l'invention et les méthodes de BRIDGMAN et de fusion de zone.

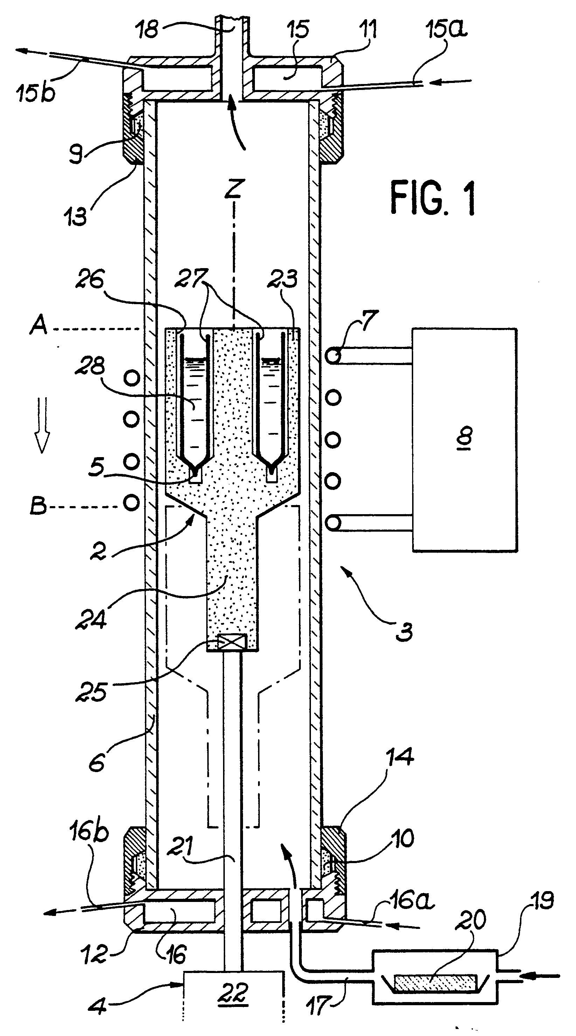

Sur la figure 1, on a représenté schématiquement un mode de réalisation particulier du dispositif objet de l'invention. Il comprend essentiellement :

- un moyen thermiquement conducteur 2 apte à contenir au moins un creuset 27 rempli du matériau à cristalliser 28,

- des moyens de chauffage 3,

- des moyens 4 de déplacement du moyen thermiquement conducteur 2 par rapport aux moyens de chauffage 3, et

- des moyens de cristallisation 5, aptes à déclencher la cristallisation du matériau lorsqu'il est extrait des moyens de chauffage 3.

Ces moyens de chauffage 3 comportent, ici, essentiellement, autour d'un tube en quartz 6 d'axe Z, disposé verticalement, des enroulements inducteurs à haute fréquence 7 qui entourent seulement une portion du tube 6 et qui sont alimentés par un générateur de courant à haute fréquence 8.

L'extrémité supérieure (respectivement inférieure) du tube 6 est munie d'un joint torique 9 (respectivement 10) et obturée par un bouchon (respectivement 12) fileté à l'extérieur et en contact avec un côté du joint torique, et par une bague 13 (respectivement 14) filetée à l'intérieur et en contact avec l'autre côté du joint torique, le bouchon étant vissé dans la bague de façon à comprimer le joint.

L'intérieur 15 ou 16 de chaque bouchon 11 ou 12 est évidé de manière à permettre la circulation d'un fluide réfrigérant introduit par un conduit 15a ou 16a à l'intérieur du bouchon 11 ou 12 et évacué par un conduit 15b ou 16b de l'intérieur dudit bouchon.

En outre, on établit une circulation d'un gaz chimiquement inerte tel que l'argon, à l'intérieur du tube 6. L'argon est introduit dans ce dernier par un conduit 17 traversant le bouchon inférieur 12 et évacué du tube 6 par un conduit 18 traversant le bouchon supérieur 11 et conduisant à des moyens de pompage non représentés. Préalablement à son introduction dans le tube 6, l'argon est débarrassé de toute trace d'eau en le faisant par exemple circuler dans un four résistif 19 communiquant avec le conduit 17 prévu pour l'introduction de l'argon dans le tube 6, le four 19 contenant des morceaux 20 du matériau commercialisé sous le nom de TEFLON qui, chauffé, se décompose pour donner du tétrafluorure de carbone qui fixe les molécules d'eau.

Les moyens de déplacement 4 comportent une tige 21 qui traverse le bouchon inférieur 12 et qui est déplaçable verticalement dans le tube 6 suivant l'axe Z, cette tige 21 étant commandée par un mécanisme de translation 22.

Le moyen thermiquement conducteur 2 est conçu pour être déplaçable verticalement suivant l'axe Z dans le tube 6 et comporte une partie supérieure 23 prolongée inférieurement par un appendice 24 pourvu à sa base d'un logement 25 dans lequel est fixée la tige 21. La partie supérieure 23 du moyen thermiquement conducteur 2 comporte plusieurs logements 26 parallèles et verticaux qui débouchent du sommet de cette partie supérieure 23 et qui sont conçus pour recevoir des creusets 27 destinés à contenir chacun le matériau à cristalliser 28.

Le moyen thermiquement conducteur 2, que l'on peut maintenant appeler porte-creusets, est destiné à être déplacé dans le tube 6 d'une position haute A dans laquelle la totalité du matériau contenu dans les différents creusets 27 se trouve à l'intérieur du domaine délimité par les enroulements 7, ceux-ci ayant une longueur prévue à cet effet, à une position basse B dans laquelle seul le sommet du porte-creusets 2 se trouve encore à l'intérieur dudit domaine.

De préférence, le porte-creusets 2 et les creusets 27 sont en graphite dit « nucléaire ».

Le fond de chaque creuset présente, de façon connue, une forme effilée sensiblement conique, propice à la formation d'un germe monocristallin du matériau contenu dans le creuset, lorsque ce matériau, fondu dans les moyens de chauffage, se solidifie en sortant de ceux-ci. C'est ainsi que le fond de chaque creuset constitue lesdits moyens de cristallisation 5.

On va maintenant expliquer le procédé d'élaboration de monocristaux mis en oeuvre dans le dispositif que l'on vient de décrire en référence à la figure 1 : les creusets 27, remplis du matériau à cristalliser, sont mis en place dans le porte-creusets 2, celui-ci étant en position haute dans le tube 6. On fait alors circuler l'argon dans ce dernier avec un débit de l'ordre de 4 litres par minute par exemple et l'on met en marche le four résistif 19. Lorsque celui-ci a atteint une température de l'ordre de 460 °C (température permettant la décomposition du TEFLON contenu dans ce four), on procède à la montée en température de l'ensemble constitué par le porte-creusets 2 et par les creusets 27 contenant le matériau à cristalliser, de manière que ledit ensemble se trouve porté à une température supérieure, de 20 °C par exemple, à la température de fusion du matériau considéré et l'on maintient ledit ensemble dans les moyens de chauffage pendant un temps suffisant, de l'ordre de 1 heure par exemple, pour avoir une bonne homogénéité de température dans l'ensemble en question. Le matériau se trouve ainsi à l'état fondu.

On opère alors une translation du porte-creusets vers le bas, la vitesse de translation étant fonction du matériau à cristalliser, de la forme du porte-creusets 2 et du nombre de creusets utilisés. Ainsi utilise-t-on une vitesse plus grande avec un seul creuset qu'avec plusieurs.

Lorsque les creusets quittent le domaine de chauffage délimité par les enroulements 7, le matériau se trouvant au fond des creusets subit un gradient thermique important, mais atténué par le porte-creusets 2, et forme alors un germe monocristallin. La descente du porte-creusets 2 se poursuivant, la formation d'un monocristal dans chaque creuset continue, la variation de température subie par le matériau quittant le domaine de chauffage étant néanmoins suffisamment forte pour que les impuretés contenues dans le matériau diffusent vers le haut de celui-ci.

En fin de translation, correspondant à la position basse B du porte-creusets 2, les monocristaux du matériau se trouvent élaborés et l'on refroidit alors lentement, avec une vitesse de l'ordre de 50 à 100 °C/heure par exemple, l'ensemble constitué par le porte-creusets 2, les creusets 27 et le matériau que ceux-ci contiennent, en agissant sur la puissance du générateur haute fréquence 8, jusqu'à ce que ledit ensemble atteigne la température ambiante (de l'ordre de 20 °C). Le générateur haute fréquence 8 et le four résistif 19 sont alors arrêtés et les monocristaux sont extraits des creusets 27. (Ces monocristaux se présentent sous la forme de lingots dont on doit ensuite couper l'extrémité supérieure en laquelle se trouvent alors concentrées les impuretés initialement réparties dans le matériau).

Il est à noter que l'automatisme du dispositif selon l'invention représenté sur la figure 1 est total dès la mise en marche de la translation du porte-creusets 2.

Le procédé expliqué ci-dessus est tout particulièrement applicable à la fabrication de monocristaux de fluorure de baryum. Ce matériau est sujet, sous excitation, à une émission de lumière qui présente une composante lente et une composante rapide, et doit, pour constituer un matériau scintillateur de bonne qualité, être purifié de façon à réduire les défauts de son réseau cristallin, pour renforcer l'intensité de la composante rapide.

Le fluorure de baryum est alors introduit dans les creusets 27 par exemple sous forme de poudre. A titre indicatif et non limitatif, dans le cas du fluorure de baryum, l'ensemble constitué par le porte-creusets, les creusets et le fluorure de baryum contenu dans ceux-ci, est porté par les moyens de chauffage 3 à des températures de l'ordre de 1380 °C et l'on utilise une vitesse de translation du porte-creusets, comprise entre 1 et 10 mm par heure. Avec trois creusets par exemple, une vitesse de l'ordre de 5 mm par heure convient.

Il est à noter que le démoulage des monocristaux de fluorure de baryum obtenus est aisé, étant donné qu'un phénomène de retrait se produit pour ce matériau lors de sa cristallisation.

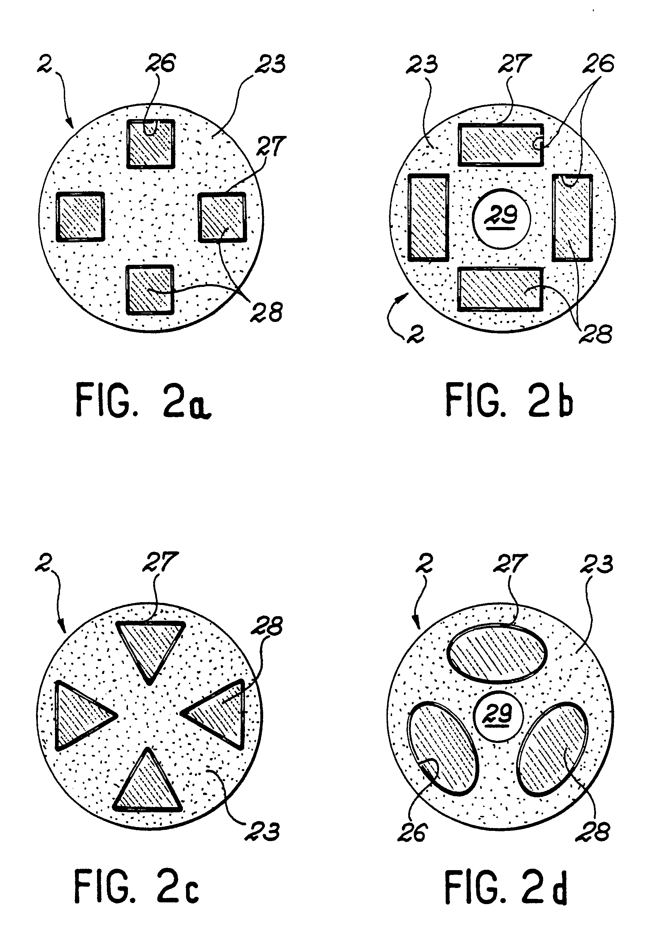

Grâce à la présente invention, on peut élaborer simultanément plusieurs monocristaux et donner à ceux-ci des formes très variées. Il suffit pour cela de donner aux creusets la forme voulue. C'est ce que l'on a représenté sur les figures 2a à 2d sur lesquelles on voit des creusets 27 qui sont régulièrement positionnés dans des porte-creusets 2 et qui présentent des sections droites carrée, rectangulaire, triangulaire et elliptique. L'invention permet par exemple de réaliser des monocristaux de section droite carrée, de 26 mm de côté et de 120 mm de longueur, dans trois creusets maintenus dans un porte-creusets cylindrique de 130 mm de diamètre.

Dans le cas où l'on utilise simultanément plusieurs creusets 27, la partie supérieure 23 du porte-creusets 2 peut comporter en son centre un évidement 29, les logements 26 prévus pour recevoir les creusets 27 étant alors répartis symétriquement autour dudit évidement 29, comme on le voit sur les figures 2b et 2d. L'évidement 29 permet d'avoir une meilleure homogénéité de température, en évitant une surchauffe au centre de la partie 23.

Les différentes formes possibles pour les monocristaux à élaborer peuvent entraîner une répartition non uniforme de température dans chaque section transverse de ces monocristaux. Ceci peut être compensé aisément par une modification de la forme et/ou de la nature du porte-creusets 2 et/ou du type de chauffage par haute fréquence (effet de peau). En procédant ainsi, et grâce au chauffage par haute fréquence (c'est-à-dire par des enroulements inducteurs à haute fréquence), le matériau à cristalliser peut être chauffé uniformément en tous points quelle que soit sa forme. Un chauffage résistif (réalisé à l'aide d'enroulements résistifs chauffant par effet Joule) est possible mais est moins homogène qu'un chauffage haute fréquence pour l'ensemble constitué par le porte-creusets et les creusets contenant le matériau à cristalliser.

On a indiqué plus haut que la position initiale du porte-creusets 2 est telle que le matériau à cristalliser se trouve au départ compris dans le domaine délimité par les enroulements 7. Bien entendu, la position initiale du porte-creusets pourrait être plus élevée dans le tube 6, le matériau à cristalliser se trouvant alors au départ en dehors du domaine de chauffage délimité par les enroulements 7, mais le temps pour élaborer les cristaux serait alors plus élevé.

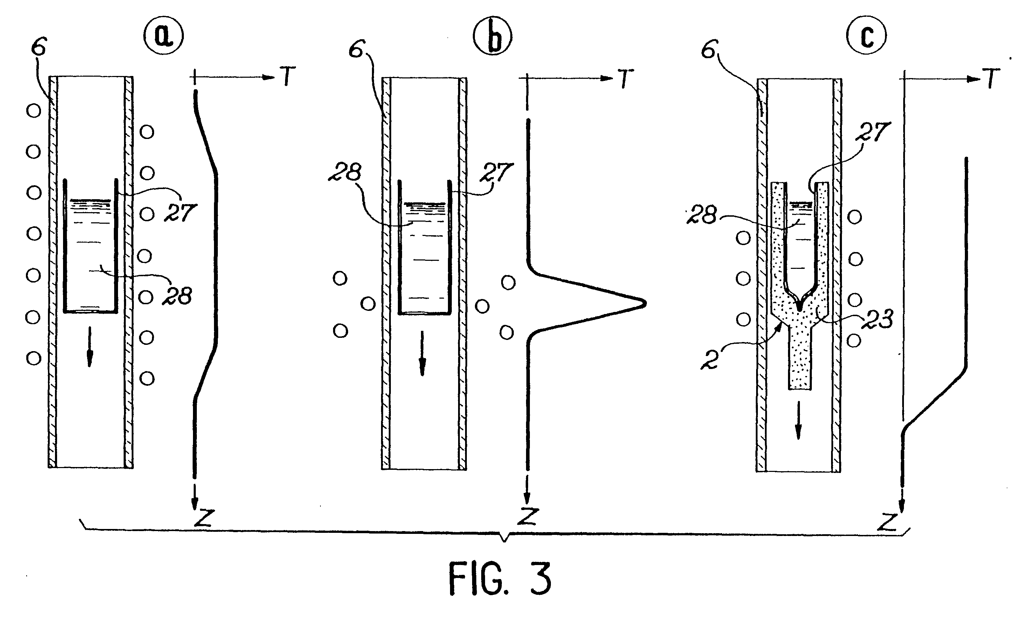

Sur les figures 3a, 3b et 3c, on a représenté des graphiques donnant la température T en fonction de la position sur l'axe Z, pour un matériau à cristalliser auquel on applique respectivement la méthode de BRIDGMAN (figure 3a), la méthode de fusion de zone (figure 3b) et un procédé utilisant le dispositif de l'invention (figure 3c).

Dans la méthode de BRIDGMAN, le gradient thermique subi par le matériau à cristalliser est faible et il n'est pas du tout question d'utiliser un porte-creusets pour atténuer ce gradient. Dans la méthode de fusion de zone, le chauffage du matériau est très localisé, le gradient thermique que subit ce matériau est très brutal. Dans la présente invention, on utilise donc précisément un porte-creusets pour homogénéiser la température du matériau et pour atténuer le gradient thermique abrupt engendré par les moyens de chauffage, gradient qui produirait seulement un effet de purification du matériau s'il n'était pas atténué.

En d'autres termes, le gradient thermique subi par le matériau dans la présente invention, est intermédiaire entre le gradient thermique qu'il subirait dans la méthode de BRIDGMAN et le gradient thermique qu'il subirait dans la méthode de fusion de zone.

D'ailleurs, en réalisant par exemple un monocristal de fluorure de baryum avec le dispositif de l'invention, on obtient des résultats bien supérieurs à ceux que l'on obtient en appliquant d'abord la méthode de fusion de zone puis la méthode de BRIDGMAN au fluorure de baryum. En effet, un monocristal de fluorure de baryum réalisé avec l'invention présente une émission lumineuse dont la composante rapide a une intensité qui est plus renforcée par rapport à la composante lente que la composante rapide d'un monocristal de fluorure de baryum obtenu en appliquant successivement la méthode de fusion de zone et la méthode de BRIDGMAN audit fluorure de baryum.

**Revendications**

1. Dispositif d'élaboration d'un monocristal à partir d'un matériau (28) apte à cristalliser, ce dispositif comprenant :
   - au moins un creuset (27) thermiquement conducteur prévu pour recevoir le matériau (28),
   - un moyen thermiquement conducteur (2) apte à recevoir chaque creuset (27),
   - des moyens de chauffage (3) dudit moyen thermiquement conducteur (2) et de chaque creuset (27) contenant ledit matériau, ces moyens de chauffage ayant une longueur au moins égale à celle de chaque creuset,
   - des moyens (4) de déplacement relatif dudit moyen thermiquement conducteur (2) et de chaque creuset (27) contenant ledit matériau (28) par rapport auxdits moyens de chauffage (3),
   le moyen thermiquement conducteur (2) comportant une partie supérieure (23), apte à recevoir chaque creuset (27), et une partie inférieure prolongeant inférieurement la partie supérieure (23) et formant un appendice (24) de cette partie supérieure (23), le fond (5) de chaque creuset étant de forme effilée, de façon à constituer des moyens de cristallisation aptes à provoquer la cristallisation d'une extrémité dudit matériau (28) fondu dans les moyens de chauffage (3), ces moyens de chauffage permettant la sortie du moyen thermiquement conducteur (2) par le bas desdits moyens de chauffage (3), et l'appendice (24) étant disposé de façon à modifier le gradient thermique subi par le matériau lors du déplacement relatif.

2. Dispositif selon la revendication 1, caractérisé en ce qu'il comporte plusieurs creusets (27), en ce que le moyen thermiquement conducteur (2) comporte un évidement (29) et en ce que les creusets (27) sont disposés symétriquement autour de cet évidement (29).

3. Dispositif selon l'une quelconque des revendications 1 et 2, caractérisé en ce que le moyen thermiquement conducteur (2) et chaque creuset (27) sont en graphite purifié.

4. Dispositif selon l'une quelconque des revendications 1 à 3, caractérisé en ce que les moyens de chauffage (3) comportent des enroulements inducteurs à haute fréquence (7).

5. Dispositif selon l'une quelconque des revendications 1 à 3, caractérisé en ce que les moyens de chauffage comportent des enroulements résistifs chauffant par effet Joule.

6. Dispositif selon l'une quelconque des revendications 1 à 5, caractérisé en ce que l'ensemble constitué par le moyen thermiquement conducteur (2), chaque creuset (27) et le matériau (28), est placé dans une enceinte (6) l'isolant de l'atmosphère extérieure.

7. Dispositif selon l'une quelconque des revendications 1 à 6, caractérisé en ce qu'il comporte en outre des moyens (17, 18, 19) de circulation d'un gaz chimiquement inerte, de manière à élaborer le monocristal en atmosphère chimiquement inerte.

8. Application du dispositif selon l'une quelconque des revendications 1 à 7, à l'élaboration de monocristaux de fluorure de baryum.

## Claims

1. Apparatus for producing a monocrystal from a crystallizable material (28), said apparatus comprising at least one thermally conductive crucible (27) for receiving the material (28), a thermally conductive means (2) able to receive each crucible (27) and means (3) for heating the thermally conductive means (2) and each crucible (27) containing the material, said heating means having a length at least equal to that of each crucible, means (4) for the relative displacement of said thermally conductive means (2) and each crucible (27) containing said material (28) with respect to said heating means (3), the thermally conductive means (2) having an upper part (23) able to receive each crucible (27) and a lower part downwardly extending the upper part (23) and forming an appendage (24) of the upper part (23), the bottom (5) of each crucible being tapered, so as to constitute crystallization means able to bring about the crystalliaation of one end of the melted material (28) in the heating means, said heating means making it possible for the thermally conductive means (2) to pass out through the base of said heating means (3) and the appendage (24) is arranged in such a way as to modify the thermal gradient undergone by the material during the relative displacement.

2. Apparatus according to claim 1, characterized in that it comprises several crucibles (27), in that the thermally conductive means (2) comprises a cavity (29) and in that the crucibles (27) are arranged symmetrically around the cavity (29).

3. Apparatus according to either of the claims 1 and 2, characterized in that the thermally conductive means (2) and each crucible (27) are made from purified graphite.

4. Apparatus according to any one of the claims 1 to 3, characterized in that the heating means (3) comprise high frequency field windings (7).

5. Apparatus according to any one of the claims 1 to 3, characterized in that the heating means comprise Joule effect-heated resistive windings.

6. Apparatus according to any one of the claims 1 to 5, characterized in that the assembly constituted by the thermally conductive means (2), each crucible (27) and the material (28) is placed in an enclosure (6) insulating it from the outside atmosphere.

7. Apparatus according to any one of the claims 1 to 6, characterized in that it also comprises means (17, 18, 19) for circulating a chemically inert gas, so as to produce the monocrystal in a chemically inert atmosphere.

8. Application of the apparatus according to any one of the claims 1 to 7, to the production of barium fluoride monocrystals.

## Patentansprüche

1. Vorrichtung zur Herstellung eines Eingriffteils aus einem kristallisierfähigen Material (28), enthaltend :

wenigstens einen thermosleitfähigen Schmelztiegel (27), der für die Aufnahme des Materials (28) bestimmt ist,

eine Wärmeleitereinrichtung (2), die zur Aufnahme eines jeden Schmelztiegels (27) eingerichtet ist,

Heizeinrichtungen (3) für die Wärmeleitereinrichtung (2) und jeden Schmelztiegel, der das genannte Material enthält, wobei diese Heizeinrichtungen eine Länge haben, die wenigstens gleich der eines jeden Schmelztiegels ist,

Einrichtungen (4) zum Relativverschieben der Wärmeleitereinrichtung (2) und jedes Schmelztiegels (27), der das genannte Material enthält (28) gegenüber den Heizeinrichtungen (3),

wobei die Wärmeleitereinrichtung (2) einen oberen Abschnitt (23) aufweist, der dazu eingerichtet ist, jeden Schmelztiegel (27) aufzunehmen, und einen unteren Abschnitt aufweist, der den oberen Abschnitt (23) nach unten verlängert und einen Fortsatz (24) dieses oberen Abschnitts (23) bildet, wobei der Boden (5) eines jeden Schmelztiegels eine zugespitzte Gestalt aufweist, um Kristallisationseinrichtungen zu bilden, die dazu geeignet sind, die Kristallisation eines Endes des in die Heizeinrichtungen abgesenkten Materials (28) hervorzurufen, wobei die Heizeinrichtungen das Austreten der Wärmeleitereinrichtung (2) durch den Boden der Heizeinrichtungen (3) erlauben und der Fortsatz (24) derart angeordnet ist, daß er den Temperaturgradienten, den das Material bei der Relativverschiebung erfährt, modifiziert.

2. Vorrichtung nach Anspruch 1, dadurch gekennzeichnet, daß sie mehrere Schmelztiegel (27) enthält, daß die Wärmeleitereinrichtung (2) einen Hohlraum (29) aufweist und daß die Schmelztiegel (27) symmetrisch um diesen Hohlraum (29) angeordnet sind.

3. Vorrichtung nach einem der Ansprüche 1 und 2, dadurch gekennzeichnet, daß die Wärmeleitereinrichtung (2) und jeder Schmelztiegel (27) aus reinem Graphit bestehen.

4. Vorrichtung nach einem der Ansprüche 1 bis 3, dadurch gekennzeichnet, daß die Heizeinrichtungen (3) Hochfrequenzinduktionsspulen (7) aufweisen.

5. Vorrichtung nach einem der Ansprüche 1 bis 3, dadurch gekennzeichnet, daß die Heizeinrichtungen Widerstandsspulen aufweisen, die durch Joule-Effekt heizen.

6. Vorrichtung nach einem der Ansprüche 1 bis 5, dadurch gekennzeichnet, daß die durch die Wärmeleitereinrichtung (2), jeden Schmelztiegel (27) und das Material (28) gebildete Anordnung sich in einem Behälter (6) befindet, der sie gegen die Außenatmosphäre isoliert.

7. Vorrichtung nach einem der Ansprüche 1 bis 6, dadurch gekennzeichnet, daß sie weiterhin Einrichtungen (17, 18, 19) zum Umwälzen eines chemisch inerten Gases aufweist, um den Einkristall in chemisch inerter Atmosphäre zu erzeugen.

8. Anwendung der Vorrichtung nach einem der Ansprüche bis 7 bei der Herstellung von Barium-fluorid-Einkristallen.

FIG. 1

FIG. 2a

FIG. 2b

FIG. 2c

FIG. 2d

FIG. 3

EP 0 130 865 B1